Europäisches Patentamt

European Patent Office

Office européen des brevets

(19)

(11) **EP 0 525 235 B1**

(12) **EUROPÄISCHE PATENTSCHRIFT**

(45) Veröffentlichungstag und Bekanntmachung des Hinweises auf die Patenterteilung:
**03.06.1998   Patentblatt 1998/23**

(51) Int Cl.$^6$: **H01L 27/22**

(21) Anmeldenummer: **91112840.3**

(22) Anmeldetag: **31.07.1991**

(54) **Hallsensor mit Selbstkompensation**

Hall sensor with self-compensation

Capteur à effet Hall à autocompensation

(84) Benannte Vertragsstaaten:
**BE CH DE FR GB IT LI NL SE**

(43) Veröffentlichungstag der Anmeldung:
**03.02.1993   Patentblatt 1993/05**

(73) Patentinhaber: **Micronas Intermetall GmbH
79108 Freiburg (DE)**

(72) Erfinder:
• **Theus, Ulrich, Dr. Ing.
79194 Gundelfingen (DE)**
• **Motz, Mario, Dipl-Ing.
D-79346 Endingen (DE)**
• **Niendorf, Jürgen, Dipl.-Ing.
D-15230 Frankfurt/Oder (DE)**

(56) Entgegenhaltungen:
**EP-A- 0 285 016          US-A- 4 705 964**

**Beschreibung**

Die Erfindung betrifft nach dem Oberbegriff des Anspruchs 1 einen kompensierten Hallsensor in monolithisch integrierter Schaltungstechnik mit einer mitintegrierten Stromversorgungseinrichtung für Betriebsströme. Die Erfindung betrifft ferner Verfahren zur Selbstkompensation eines Hallsensors bezüglich der herstellungsbedingten Empfindlichkeit und Temperaturabhängigkeit des Hallelements mit und ohne Hysterese-Schalteinrichtung, vgl. hierzu den Wortlaut der unabhängigen Ansprüche 7 und 14, 15, 16.

Monolithisch integrierte Hallsensoren sind handelsüblich und kommen über ihre eigentliche Verwendung als Meßeinrichtungen für Magnetfelder hinaus immer mehr dort zum Einsatz, wo ein kontaktloses Schalten bewirkt werden soll. Ein derartiges Gebiet ist beispielsweise die Drehzahlmessung im Getriebe- oder im Tachometerbereich von Kraftfahrzeugen. Bei derartigen Schalteranwendungen wird mittels der Hallspannung die Richtung und Größe eines wechselnden oder unipolaren Magnetfeldes bestimmt und beim Überschreiten einer Schaltschwelle ein Zählimpuls ausgelöst. Der elektronische Schalter, der z.B. durch den offenen Kollektor eines Transistors dargestellt wird, ist meist mitintegriert und somit Teil des Hallsensors. Für die Schalteranwendung enthalten die Hallsensoren in der Regel verstärkende Fühlereinrichtungen oder Pufferverstärker, Schmitt-Triggerstufen mit Hystereseverhalten und Strom- und/oder Spannungsversorgungseinrichtungen.

Ein Nachteil der bekannten Hallsensoren ist, daß die Kompensation der herstellungsbedingten Empfindlichkeitsunterschiede und der Temperaturabhängigkeit des Hallelements durch individuelle Abgleichmaßnahmen bei der Chipherstellung erfolgen muß.

Es ist daher Aufgabe der in den Ansprüchen gekennzeichneten Erfindung, eine Schaltung und das ihr zugrundeliegende Verfahren für einen kompensierten Hallsensor anzugeben, der ohne individuelle Abgleichmaßnahmen eine Selbstkompensation der technologie- und temperaturbedingten Empfindlichkeitsunterschiede ermöglicht.

Der Vorteil der Erfindung liegt im wesentlichen im Fortfall des individuellen Abgleichs, wodurch eine einfachere und halbleitergerechtere Bauelementeherstellung ermöglicht wird. Die erforderliche Chipfläche verkleinert sich zudem um die nicht vernachlässigbare Fläche der ansonsten benötigten Abgleichkontakte. Die Selbstkompensation ist sowohl auf lineare Hallsensoren für Meßanwendungen als auch auf Hallsensoren mit einer Schaltfunktion, z.B. auch einer Hysterese-Schaltfunktion, anwendbar. Es ergibt sich ferner auch die Möglichkeit, die Temperaturabhängigkeit der Hallsensoren in Grenzen vorzugeben. Da die Selbstkompensation lediglich durch den Gleichlauf technologiebedingter Herstellungsparameter auf dem jeweiligen Halbleiterkristall gesteuert wird, werden auch nichtlineare Effekte dieser Parameter weitgehend kompensiert.

Einer der Grundgedanken der Erfindung besteht darin, daß die Betriebsströme des Hallelements durch eine Stromversorgungseinrichtung auf dem Halbleiterchip, also in thermischer und technologischer Kopplung mit der Hallelement-Halbleiterzone erzeugt werden. Die Hallspannung (= uh) ist von den technologischen Parametern, der absoluten Temperatur (= T) und der Bezugstemperatur (= To) der Hallelement-Halbleiterzone wie folgt abhängig:

$$(1) \qquad uh(T) = \mu_H(T) \times R(T) \times iv(T) \times B,$$

mit folgenden näheren Bestimmungen:
temperatur- und materialabhängige Hall-Beweglichkeit $= \mu_H$,

$$(1.1) \qquad \mu_H(T) = \mu(To) \times 1/(1 + a \times \Delta T),$$

Bezugstemperaturdifferenz $= \Delta T = T - To$,
ohmscher Widerstand des Hallelements $= R(T)$,

$$R(T) = R(To) \times (1 + a \times \Delta T),$$

Versorgungsstrom des Hallelements $= iv(T)$,
magnetische Induktion $= B$,
Temperaturkoeffizient des Schichtwiderstandes (= r') der Hallelement-Halbleiterzone $= a$ bei der Bezugstemperatur.

Die Temperatur- und Technologieabhängigkeit der Hallspannung ergibt sich durch Einsetzung der einzelnen Abhängigkeiten in die Gleichung (1). Dabei kürzt sich der technologieabhängige Faktor $(1 + a \times \Delta T)$ heraus, so daß nur noch die Temperaturabhängigkeit des Versorgungsstromes $iv(T)$ in die Hallspannung uh (T) eingeht, wenn die magnetische Induktion B temperaturunabhängig ist.

$$(2) \qquad uh(T) = \text{Proportionalitätsfaktor} \times iv(T)$$

Die Gleichung (2) zeigt, daß die Hallspannung in ihrer Temperaturabhängigkeit fest an die Versorgungsstrom-Temperaturabhängigkeit gekoppelt ist. Hierbei ist natürlich besonders interessant, daß die Hallspannung dann keine Temperaturabhängigkeit aufweist, wenn die Temperaturabhängigkeit des Versorgungsstromes auf Null abgeglichen ist.

Wird der Hallspannung uh eine Offsetspannung (= uj) mittels eines Offsetstromes (= j) an den Meßeingängen des Hallelements überlagert, dann ergibt sich für die Offsetspannung folgender Wert:

$$(3) \qquad uj(T) = j(T) \times rh(T),$$

wobei der Hallelement-Ersatzwiderstand = rh ist, und damit ist

$$(4) \qquad uj(T) = j(T) \times rh(To) \times (1 + a \times \Delta T).$$

Für den Temperatur-Nullabgleich der Offsetspannung bei der Bezugstemperatur To muß somit folgende Bedingung für den Offsetstrom j(T) erfüllt sein:

$$(5) \qquad j(T) = j(To) \times 1/(1 + a \times \Delta T).$$

Für den Gleichgang, insbesondere beim Nullabgleich, der Temperaturabhängigkeit der Hallspannung und der Offsetspannung muß folgende Bedingung erfüllt sein, die sich aus den Gleichungen (2) und (5) ergibt:

$$(6) \qquad \Delta iv(T)/ \Delta j(T) = 1 + a \times \Delta T.$$

Gleichung (6) verknüpft dabei das Verhältnis aus den Temperaturabhängigkeiten der Betriebsströme des Hallelements mit der Temperaturabhängigkeit des Schichtwiderstandes (= r') der Hallelement-Halbleiterzone, die durch den Faktor $(1 + a \times \Delta T)$ definiert ist. Der absolute Wert der Temperaturabhängigkeiten der Betriebsströme ist nach Gleichung (6) somit für jeweils einen der Betriebsströme iv oder j frei vorgebbar. Da Gleichung (6) für jede Bezugstemperatur To und für den gesamten Betriebs-Temperaturbereich gilt, stellt sie ein ausgezeichnetes Bewertungskriterium dar, um die Temperaturkompensation verschiedener Schaltungsvarianten miteinander zu vergleichen.

Die Erfindung macht sich ferner die Erkenntnis zu Nutze, daß durch Summen- oder Differenzbildung von Strömen mit unterschiedlichen Temperaturabhängigkeiten resultierende Ströme mit anderen Temperaturabhängigkeiten gebildet werden können. Dieses Verfahren ist um so reproduzierbarer, je größer die unterschiedlichen Temperaturabhängigkeiten sind. Gemäß der Erfindung wird auf dem Hallsensor eine Stromversorgungseinrichtung für mindestens zwei Hilfsströme mit unterschiedlichem Temperaturverhalten mitintegriert. Das jeweilige Temperaturverhalten wird dabei näherungsweise als linear angenommen, wobei bei einer Bezugstemperatur To, z.B. 333 Kelvin, der relative Steigungswert bestimmt wird. Dabei wird der relative Steigungswert zweckmäßigerweise als positiver oder negativer ppm-Wert (= parts per million) angegeben. Durch Addition oder Subtraktion der jeweiligen ppm-Werte lassen sich nämlich auf einfache Weise die zugehörigen Stromanteile oder Gewichtungsfaktoren der Hilfsströme bei der jeweiligen Bezugstemperatur To bestimmen, die zu dem neuen Strom mit dem gewünschten Temperaturkoeffizient bei der Bezugstemperatur To führen. Wie gut diese Temperaturabstimmung über dem gesamten Temperaturbereich ist, läßt sich ohne Kenntnis der genauen Temperaturverläufe außerhalb der Bezugstemperatur To nicht ermitteln. Die Näherung kann da mehr oder weniger gut sein.

Folgendes einfache Beispiel mit zwei gleichgroßen Hilfsströmen I1, I2 soll die Bestimmung der Gewichtungsfaktoren veranschaulichen. I1 hat eine Temperaturabhängigkeit von + 5000 ppm und I2 hat eine Temperaturabhängigkeit von - 2000 ppm. Durch Summenbildung mit dem Gewichtungsfaktor 2,5 für I2 wird ein Summenstrom erzeugt, dessen Temperaturabhängigkeit 0 ppm beträgt und somit mindestens bei der Bezugstemperatur keine Temperaturabhängigkeit aufweist. I1 + 2,5 x I2 ergibt in der einfachen ppm-Schreibweise:

$$5000 \text{ ppm} + (-2,5 \times 2000 \text{ ppm}) = 0 \text{ ppm}.$$

Die Differenzbildung mit einem Gewichtungsfaktor 2 für I2 erzeugt einen Differenzstrom I1 - 2 x I2, dessen Temperaturabhängigkeit im Bezugspunkt in der einfachen ppm-Schreibweise folgenden Wert ergibt:

$$5000 \text{ ppm} - (- 2 \text{ x } 2000 \text{ ppm}) = 9000 \text{ ppm}.$$

Für die ausreichende Reproduzierbarkeit der Ströme und die Zulässigkeit der einfachen Berechnung der Gewichtungsfaktoren über die ppm-Darstellung sollte der Differenzstrom in der Größenordnung der Einzelströme I1 oder I2 bleiben. Die Erzeugung von Strömen mit unterschiedlichen Temperaturabhängigkeiten wird anhand der Ausführungsbeispiele ausführlich erläutert.

Aus Gleichung (6) ergeben sich für die Hysterese-Schaltempfindlichkeit zweckmäßige Realisierungen zur Selbstkompensation, je nach dem, welche Abhängigkeiten der Versorgungsstrom iv(T) aufweist. Daß dabei der Schichtwiderstand r' der Hallelement-Halbleiterzone als gemeinsamer Faktor in die Größe des Versorgungsstromes iv und des Offsetstromes j mit eingeht, wird für diese Betrachtung vorausgesetzt.

Erster Fall: Ist iv(T) konstant und temperaturunabhängig, dann ist auch uh(T) konstant, aber der Offsetstrom j(T) muß in seiner Temperaturabhängigkeit folgender Bedingung folgen:

$$(7) \qquad j(T) = j(To)/(1 + a \text{ x } \Delta T).$$

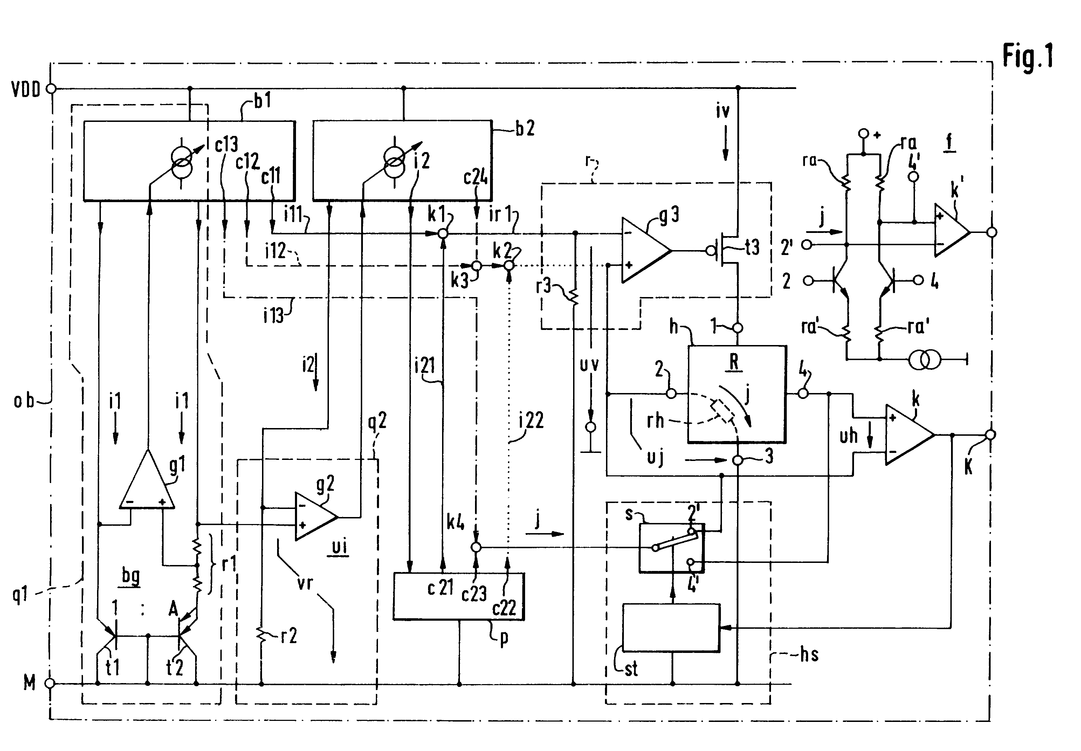

Fig. 1 zeigt hierzu ein bevorzugtes Ausführungsbeispiel.

Zweiter Fall: Ein anderer vorteilhafter Betrieb für den Hallsensor ergibt sich, wenn das Hallelement direkt von der Versorgungsspannung VDD gespeist wird, weil dann der Versorgungsstrom iv und damit die Hallempfindlichkeit am größten wird. In diesem Falle geht in die Größe des Versorgungsstromes iv selbstverständlich der jeweilige Wert der Versorgungsspannung VDD und ihre in der Regel vorhandene Temperaturabhängigkeit VDD(T) mit ein und zusätzlich die Temperaturabhängigkeit der Hallelement-Halbleiterzone. Der Versorgungsstrom iv(T) ist damit durch folgende Gleichung bestimmt, wobei VDDo einen festen Versorgungsspannungs-Bezugswert oder Normierungswert für die Gleichung darstellt:

$$(8) \qquad iv(T, VDD) = iv(To) \text{ x } (VDD/VDDo)/(1 + a \text{ x } \Delta T).$$

Aus Gleichung (6) ergibt sich, daß der Offsetstrom j(T) auch die Abhängigkeit von der Versorgungsspannung VDD aufweisen muß. Die Temperaturabhängigkeit der Hallelement-Halbleiterzone muß jedoch mit dem Faktor $1/(1 + a \text{ x } \Delta T)^2$ in die Größe des Offsetstromes mit eingehen. Damit ergibt sich folgende Bestimmungsgleichung für den Offsetstrom j(T):

$$(9) \qquad j(T, VDD) = j(To) \text{ x } (VDD/VDDo)/(1 + a \text{ x } \Delta T)^2.$$

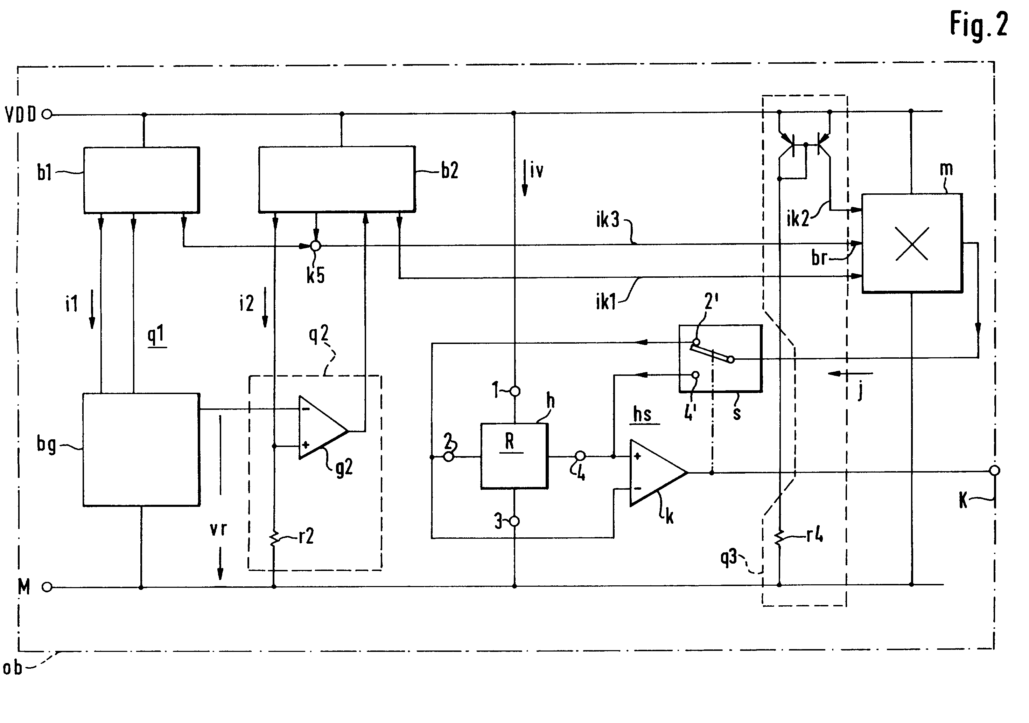

Die gewünschte Temperaturabhängigkeit wird hierbei durch die Multiplikation einer ersten Stromkomponente ik1 mit einer zweiten Stromkomponente ik2 erreicht, wobei ik1 proportional zu $1/(1 + a \text{ x } \Delta T)$ und ik2 proportional zu $(VDD/VDDo)/(1 + a \text{ x } \Delta T)$ ist. Damit wird ik1 x ik2 = j wie gewünscht proportional zu $(VDD/VDDo)/(1 + a \text{ x } \Delta T)^2$. Für die Strommultiplikation wird als Bezugsstrom noch eine dritte Stromkomponente ik3 mit dem Temperaturkoeffizient Null benötigt. Ein bevorzugtes Ausführungsbeispiel zum zweiten Fall stellt Fig. 2 dar.

Dritter Fall: schließlich erweist sich auch ein Betrieb von Vorteil, bei dem das Hallelement von einer temperaturstabilisierten Hallelement-Versorgungsspannung (= V) und nicht von der ungeregelten Versorgungsspannung VDD gespeist wird. Anstatt einer Multiplikation von zwei unterschiedlichen Stromkomponenten ik1, ik2 ist dann lediglich die Quadrierung der Stromkomponente ik1 erforderlich. Der Bezugsstrom ik3 mit dem Temperaturkoeffizient Null wird weiterhin benötigt. Der Offsetstrom j(T) wird dabei durch folgende Gleichung bestimmt:

$$(10) \qquad j(T) = j(To)/(1 + a \text{ x } \Delta T)^2.$$

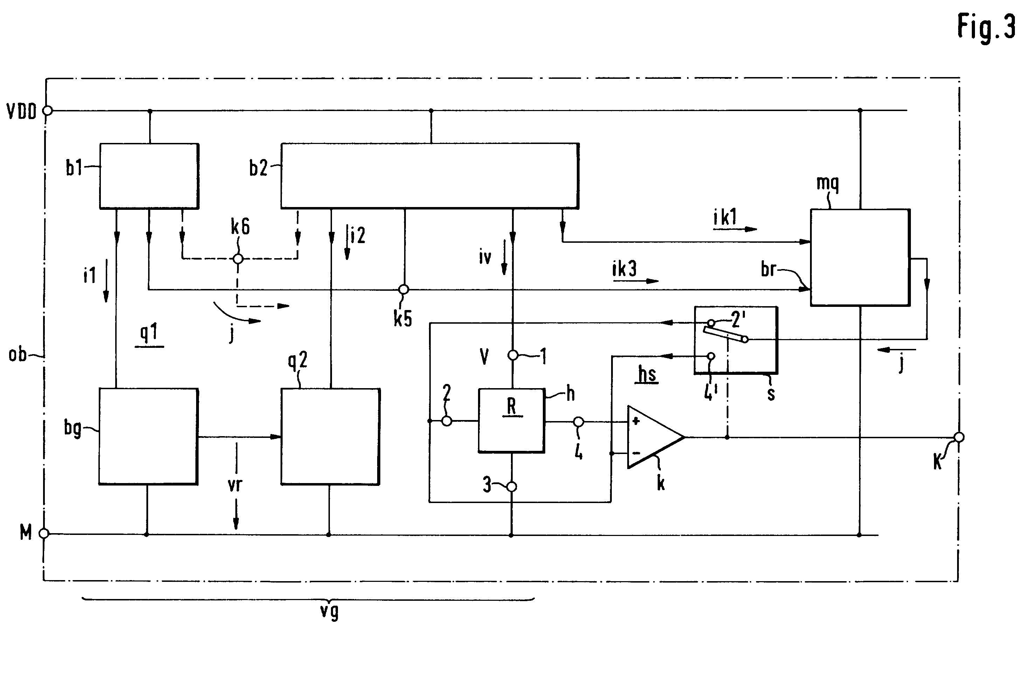

Eine weitere Vereinfachung ist möglich, wenn a x $\Delta T$ klein gegen 1 wird, weil dann der quadratische Faktor $1/(1 + a \text{ x } \Delta T)^2$ näherungsweise durch den Faktor $1/(1 + 2 \text{ x } a \text{ x } \Delta T)$ ersetzt werden kann, was wieder über eine Addition oder Subtraktion von Strömen mit unterschiedlichem Temperaturverhalten realisierbar ist. Dies gilt übrigens auch für den quadratischen Faktor in (8) und (9). Ein bevorzugtes Ausführungsbeispiel für diesen dritten Fall zeigt Fig. 3.

Die Erfindung und weitere Vorteile werden nun anhand der Figuren der Zeichnung näher erläutert:

Fig. 1 zeigt schematisch als Blockschaltbild ein bevorzugtes erstes Ausführungsbeispiel eines Hallsensors mit Hysterese-Schalteinrichtung,

Fig. 2 zeigt schematisch ein bevorzugtes zweites Ausführungsbeispiel mit direkter Speisung des Hallelements aus der Versorgungsspannung VVD und

Fig. 3 zeigt ein bevorzugtes drittes Ausführungsbeispiel mit einer temperaturstabilisierten Hallelement-Versorgungsspannung V.

In Fig. 1 ist schematisch ein erstes Ausführungsbeispiel eines Hallsensors mit Hysterese-Schalteinrichtung dargestellt. Dabei handelt es sich um einen selbstkompensierenden Hallsensor, der in monolithisch integrierter Schaltungstechnik ausgeführt ist und bei dem sämtliche Stromversorgungseinrichtungen für die Betriebsströme auf der Halbleiteroberfläche ob mitintegriert sind. Dabei ist der Hallsensor als Dreibeinelement ausgeführt, und erfordert lediglich Anschlüsse für eine Versorgungsspannung VDD, einen Masseanschluß M und eine Ausgangsklemme K, an der das Ausgangssignal des Hallsensors niederohmig abzugreifen ist.

Das Ausführungsbeispiel nach Fig. 1 enthält eine Hysterese-Schalteinrichtung hs, die der Hallspannung uh eine Offsetspannung uj überlagert, um ein definiertes Schalten eines Komperators k zu bewirken, der an die Fühlereingänge 2 und 4 des Hallelements h angeschlossen ist. Bei dem dargestellten Hallelement h handelt es sich lediglich um eine vereinfachte Darstellung, weil in der Regel zwei parallel geschaltete Hallelemente verwendet werden, die aus Gründen des Kristallgitters um 90° gegeneinander gedreht sind und gegenüber der Kristallkante eine Orientierung von 45° aufweisen.

Damit der Hallsensor als periodischer Schalter verwendet werden kann, wird die Offsetspannung uj alternierend umgeschaltet, wobei die Umschaltung durch die jeweilige Stellung des Komperators k erfolgt. Der Ausgang des Komperators k ist hierzu mit einer Steuereinrichtung st verbunden, die die jeweilige Stellung eines elektronischen Umschalters s, steuert. Je nach dessen Stellung wird ein Offsetstrom j entweder über den Fühlereingang 2 oder über den Fühlereingang 4 in das Hallelement h eingespeist. Dieser Offsetstrom j erzeugt über dem Hallelement-Ersatzwiderstand rh zwischen dem jeweiligen Fühleranschluß 2 oder 4 und dem Masseanschluß 3 die Offsetspannung uj.

Für quantitative Magnetfeldmessungen kann die Hysterese-Schalteinrichtung hs entfallen. Der Komperator k wird dann durch eine lineare Fühlereinrichtung für die Hallspannung uh ersetzt, die die jeweilige Hallspannung uh hochohmig abgreift und als entsprechender Spannungswert niederohmig an der Ausgangsklemme K zur Verfügung stellt.

Die Überlagerung des Offsetstromes j muß nicht unbedingt direkt am Hallelement h erfolgen, sondern kann auch Teil einer entkoppelten Überlagerungseinrichtung f sein, die als zusätzliches Schaltungsdetail in Fig. 1 dargestellt ist. Die Entkopplungsschaltung besteht dabei aus zwei parallel geschalteten Transistorstufen, deren Verstärkungen mittels gleicher Hilfswiderstände ra, ra' jeweils auf den gleichen Verstärkungsfaktor eingestellt sind. An den Kollektoranschlüssen 2', 4', an denen auch der Offsetstrom j eingespeist wird, ist der Komperator k' angeschlossen. Die Basisanschlüsse 2 und 4 bzw. die Kollektoranschlüsse 2' und 4' liegen dabei an den nummergleichen Anschlüssen des Hallelements h bzw. elektronischen Umschalters s. Das ausgeführte Beispiel für die entkoppelte Überlagerungseinrichtung f dient lediglich der Erläuterung. Andere Ausführungsbeispiele hierzu, auch mit Feldeffekttransistoren, liegen im Bereich fachmännischen Handelns. Der Offsetstrom j, oder ein Teil von ihm, kann auch ohne die Hysterese-Schalteinrichtung hs die Hallspannung uh unsymmetrisch überlagern.

Es wird hier ausdrücklich darauf hingewiesen, daß die Ausführungsbeispiele sowohl in Bipolar- als auch in Feldeffekt- oder in einer Mischtechnologie monolithisch integriert werden können. Die Anpassung der einzelnen Schaltungsparameter und die jeweils zweckmäßigste Ausbildung der einzelnen Schaltungsgruppen liegt dabei im Bereich fachmännischen Handelns.

Die eigentlichen Betriebsströme für das Hallelement h, nämlich ein Versorgungsstrom iv und der bereits angesprochene Offsetstrom j werden durch eine Stromversorgungseinrichtung erzeugt, die auf der Halbleiteroberfläche ob mitintegriert ist. Dies ermöglicht eine technologische und thermische Kopplung der Betriebsströme an die herstellungsbedingten Streuungen der Hallelement-Halbleiterzone und deren jeweilige Betriebstemperatur T. Die Stromversorgungseinrichtung enthält hierzu eine erste und eine zweite Stromquelle q1, q2 für einen ersten bzw. einen zweiten Hilfsstrom i1, i2 mit einer ersten bzw. einer zweiten Temperaturabhängigkeit. Dabei enthält die erste und die zweite Stromquelle q1, q2 jeweils mindestens einen ersten bzw. einen zweiten Widerstand r1, r2 dessen Halbleiterzone technologisch äquivalent zur Halbleiterzone des Hallelements h ist. Die erste Stromquelle q1 enthält beispielsweise eine Bandgap-Schaltung bg mit einem Transistorpaar t1, t2, wobei deren Emitter-Flächenverhältnis den Wert A, beispielsweise A = 14, aufweist. Der erste Widerstand r1 zur Strombestimmung des ersten Hilfsstroms i1 besteht beispielsweise aus der Serienschaltung von zwei Widerständen mit 24 Kiloohm und 207 Kiloohm.

Bekanntlich besteht die Wirkungsweise der Bandgap-Schaltung darin, daß durch eine Regelschaltung die gleichgroßen Emitterströme des Transistorpaares t1, t2 auf einen solchen Wert geregelt werden, daß die Basis-Emitter-Spannungsdifferenz, die durch das Emitter-Flächenverhältnis A bewirkt wird, gleichgroß wie der Spannungsabfall an demjenigen Teilwiderstand von r1 ist, der an dem Spannungsvergleich teilnimmt. Dieser Spannungsvergleich erfolgt durch den ersten Regelverstärker g1, dessen Eingänge mit dem Emitter des ersten Transistors t1 und mit dem Spannungsteilerabgriff des ersten Widerstandes r1 verbunden sind.

Der Ausgang dieses ersten Regelverstärkers g1 ist mit dem Steuereingang einer steuerbaren Strombank verbunden, die über unterschiedliche Übersetzungsverhältnisse einen ersten Stromumsetzer bl bildet. Mit der angegebenen Dimensionierung liefert die Bandgap-Schaltung bg für die Transistoren t1, t2 jeweils einen Emitterstrom von 5,7 Mikroampere - dies ist der erste Hilfsstrom i1.

Das in Fig. 1 dargestellte Ausführungsbeispiel der Bandgap-Schaltung ist lediglich als ein Beispiel anzusehen, das jedoch den Vorteil hat, daß es auch bei einer Feldeffekt-Technologie verwendet werden kann. Das Transistorpaar t1, t2 ist nämlich aus Substrat-Transistoren gebildet, die auch in CMOS-Technologie einfach realisierbar sind.

Ein weiterer Vorteil der Bandgap-Schaltung bg ist, daß sie zusätzlich eine temperaturstabilisierte Bandgap-Spannung vr abgibt, die der zweiten Stromquelle q2 als Referenzspannung zugeführt ist. Im einfachsten Fall enthält die zweite Stromquelle q2 lediglich einen zweiten Widerstand r2, der technologisch äquivalent zur Hallelement-Halbleiterzone ist und einen zweiten Regelverstärker g2, der die Spannung am zweiten Widerstand r2 mit der Bandgap-Spannung vr vergleicht. Dabei wird der Strom durch den zweiten Widerstand r2, nämlich der zweite Hilfsstrom i2 solange mittels einer zweiten steuerbaren Strombank, dem zweiten Stromumsetzer b2, nachgeregelt, bis die Spannung am zweiten Widerstand r2 und die Bandgap-Spannung vr gleichgroß sind. Die zweite Stromquelle q2 wirkt somit als Spannungs-Stromumsetzer ui.

Die Temperaturabhängigkeit des ersten Hilfsstroms i1 ist durch die Bandgap-Schaltung bg wie folgt festgelegt:

$$(11) \qquad i1(T) = i1(To) \times (T/To)/(1 + a \times \Delta T).$$

Durch die temperaturstabilisierte Bandgap-Spannung vr ergibt sich für den zweiten Hilfsstrom i2 folgende Temperaturabhängigkeit:

$$(12) \qquad i2(T) = i2(To)/(1 + a \times \Delta T).$$

Wenn die Referenz-Spannung vr des Spannungs-Stromumsetzers ui nicht temperaturunabhängig sondern durch einen Temperaturkoeffizient b (= zweiter Koeffizient) bestimmt ist, dann müßte diese Temperaturabhängigkeit als zusätzlicher Faktor 1 + b x ΔT in die Bestimmungsgleichung (12) aufgenommen werden. Sie hätte dann folgendes Aussehen:

$$(13) \qquad i2(T) = i2(To) \times (1 + b \times \Delta T)/(1 + a \times \Delta T).$$

Eine definierte, mit der jeweiligen Technologie zusammenhängende Temperaturabhängigkeit der Referenzspannung vr ist beispielsweise dadurch zu realisieren, daß diese Spannung aus der Temperaturabhängigkeit einer oder mehrerer Basis-Emitterstrecken abgeleitet wird. Dies kann einfach in einer entsprechenden Bandgap-Schaltung als Zusatzschaltung realisiert werden.

Zur Verdeutlichung des Ausführungsbeispiels nach Fig. 1 werden folgende Beispielswerte angegeben: mit einer temperaturstabilisierten Bandgap-Spannung vr von 1,2 V und einem Widerstand r2 von 39 Kiloohm wird ein zweiter Hilfsstrom i2 von 21 Mikroampere eingestellt. Der Temperaturkoeffizient a der Hallelement-Halbleiterzone ergibt sich mit + 6220 ppm bei der angenommenen CMOS-Technologie aus dem Schichtwiderstand r' der n-Wanne. Dies ergibt für den ersten bzw. zweiten Hilfsstrom i1, i2 einen Temperaturkoeffizient von - 2887 ppm bzw. - 6220 ppm bei einer Bezugstemperatur To von 333 Grad Kelvin.

Das Ausführungsbeispiel nach Fig. 1 geht von der Vorgabe aus, daß die Hallspannung uh(T) temperaturunabhängig sein soll, was nach Gleichung (2) voraussetzt, daß auch der Versorgungsstrom iv(T) temperaturunabhängig sein muß. Dies wird in dem dargestellten Ausführungsbeispiel dadurch realisiert, daß der erste und der zweite Stromumsetzer b1, b2 erste bzw. zweite Teilströme i11, i12,...; i21, i22,.... liefert, die fest vorgegebene Übersetzungsverhältnisse c11, c12, ...; c21, c22,... gegenüber dem ersten bzw. zweiten Hilfsstrom i1, i2 aufweisen. Mittels Addier/Subtrahiereinrichtungen werden durch Summen/Differenzbildung der ersten und zweiten Teilströme die Betriebsströme iv, j mit den gewünschten Temperaturabhängigkeiten erzeugt, die über die festgelegten Teilstromverhältnisse, die sich aus den Gewichtungsfaktoren c11, ... ergeben, eingestellt sind. Die Addier/Subtrahiereinrichtungen sind dabei durch Schaltungsknoten k1, k2, ... gebildet, denen die jeweiligen Teilströme zugeführt sind.

Bei einer Stromaddition werden die beiden Teilströme direkt aus den beiden Stromumsetzern b1, b2 dem jeweiligen Schaltungsknoten zugeführt, während bei einer Subtraktion jeweils ein Teilstrom mittels eines Stromspiegels p in der Stromflußrichtung gedreht wird, bevor er dem zugehörigen Schaltungsknoten zugeführt wird. Bei der Addition der Ströme addieren sich für die Bezugstemperatur die vorzeichenrichtigen ppm-Werte und bei der Subtraktion wird derjenige ppm-Wert in seinem Vorzeichen vor der Addition invertiert, dessen Teilstrom mittels des Stromspiegels p in seiner Richtung verändert wurde.

Auf diese Weise könnte der temperaturunabhängige Versorgungsstrom iv aus zwei Teilströmen gebildet werden, wobei der resultierende Strom über ein geeignetes Übersetzungsverhältnis allerdings sehr hoch verstärkt werden müßte, weil der aktuelle Hallelement-Versorgungsstrom iv beispielsweise 7 Milliampere beträgt. Daher wurde im Ausführungsbeispiel nach Fig. 1 ein anderer Weg bestritten, indem der Versorgungsstrom über einen Regelverstärker r erzeugt wird, der den Versorgungsstrom iv so lange nachregelt, bis Spannungsgleichheit zwischen dem Fühlereingang 2 am Hallelement h und einer Vergleichsspannung uv vorliegt. Die Regelung erfolgt durch einen dritten Regelverstärker g3, dessen Ausgang mit dem Gate-Anschluß eines p-Kanal-Transistors t3 verbunden ist, der als Stromsteuerelement zwischen der Versorgungsspannung VDD und dem Hallelement-Versorgungsanschluß 1 liegt. Die Vergleichsspannung uv wird durch einen dritten Widerstand r3 gebildet, der technologisch äquivalent zur Hallelement-Halbleiterzone ist und von einem temperaturunabhängigen Strom ir1 aus einem ersten Schaltungsknoten k1 gespeist ist. Für das Ausführungsbeispiel ergibt sich: ir1 = 24 Mikroampere, weil i11 = 45 Mikroampere und i21 = 21 Mikroampere beträgt. Die Gewichtungsfaktoren c11, c21, ... werden dabei über die Größe des jeweiligen Teilstromes i11, i21, ... definiert.

Durch die spezielle Verkopplung der beiden Stromquellen q1, q2 hat der Ausgangsstrom des zweiten Stromumsetzers b2 die aus Gleichung (7) geforderte Temperaturabhängigkeit des Offsetstromes j(T). Daher wird der Offsetstrom j mit dem Gewichtungsfaktor c23 am Ausgang des Stromspiegels p abgegriffen, dessen Eingang vom zweiten Stromumsetzer b2 mit dem zweiten Hilfsstrom i2 gespeist ist. Im angenommenen Beispiel beträgt der Eingangsstrom des Stromspiegels 21 Mikroampere und der Gewichtungsfaktor c23 entspricht einem Strom von 0,74 Mikroampere. Der Versorgungsstrom iv ist damit etwa 10.000 x größer als der Offsetstrom j.

Im Ausführungsbeispiel nach Fig. 1 ist eine vom Stromspiegel p über den zweiten Schaltungsknoten k2 gehende punktierte Linie dargestellt, die über den Gewichtungsfaktor c22 gegebenenfalls einen konstanten Offsetstrom in den Fühlereingang 2 des Hallelements h einspeist, und dort eine asymmetrische Verschiebung der Hallspannung uh bewirkt.

Die gestrichelt dargestellten Linien aus dem ersten und zweiten Stromumsetzer b1, b2 mit den Gewichtungsfaktoren c12 bzw. c24 sollen andeuten, daß bei anderen ppm-Werten der Offsetstrom j aus anders gewichteten Teilströmen mittels des dritten Schaltungsknotens k3 gebildet werden kann.

Schließlich ist durch eine strichpunktierte Linie ein weiterer Ausgang des ersten Stromumsetzers b1, dessen Gewichtungsfaktor c13 ist, mit einem vierten Schaltungsknoten k4 verbunden, der bereits vom Stromspiegel p mit dem Gewichtungsfaktor c23 gespeist ist. Diese strichpunktierte Linie soll schematisch darstellen, daß durch Optimierung der Gewichtungsfaktoren auch nichtlineare Effekte bei der Addition/Subtraktion der Ströme berücksichtigt werden können, wodurch eine weitere Kompensationsmöglichkeit für Effekte höherer Ordnung gegeben ist. Neben dem reinen Steigungswert bei der Bezugstemperatur To kann der Krümmungsverlauf der Teilströme im gesamten Temperaturbereich berücksichtigt werden, so daß sich im Mittel die Kompensation verbessert. Die Gewichtungsfaktoren, die sich aus dieser Optimierung ergeben, unterscheiden sich von den Gewichtungsfaktoren, die nur die Bezugstemperatur To berücksichtigen. Die Bedingungen aus Gleichung (6) dürfen hierbei jedoch nicht verletzt werden.

Die Ausführungsbeispiele nach Fig. 2 und Fig. 3 zeigen im Bereich der Stromversorgungseinrichtung und der Hysterese-Schalteinrichtung hs teilweise die gleichen Funktionseinheiten wie Fig. 1 - die Bezugszeichen sind somit gleich und eine nochmalige Beschreibung erübrigt sich. Im Unterschied zu Fig. 1 ist in Fig. 2 jedoch das Hallelement h direkt an die Versorgungsspannung VDD angeschlossen. Dadurch wird der Versorgungsstrom iv nur durch den ohmschen Widerstand R des Hallelements h begrenzt. Dies ergibt bei einer vorgegebenen Versorgungsspannung VDD die größtmögliche Magnetfeldempfindlichkeit.

Die Bedingungen für den Offset-Strom j(T) ergeben sich aus Gleichung (9). Wesentlich dabei ist, daß der temperatur- und materialabhängige Faktor $1 + a \times \Delta T$ quadratisch in die Gleichung (9) eingeht. Mit dem Ausführungsbeispiel nach Fig. 2 wird dies dadurch realisiert, daß mittels einer Multipliziereinrichtung m eine erste und eine zweite Stromkomponente ik1, ik2 miteinander multipliziert werden. Die erste Stromkomponente ik1 ist aus dem zweiten Hilfsstrom i2 abgeleitet, dessen Temperaturabhängigkeit durch die Gleichung (12) gegeben ist. Die zweite Stromkomponente ik2 muß dabei proportional zur Versorgungsspannung VDD und reziprok zum Schichtwiderstand r' der Hallelement-Halbleiterzone sein. Daraus ergibt sich folgende Bestimmungsgleichung für die zweite Stromkomponente ik2:

$$(14) \qquad ik2(T,VDD) = ik2(To) \times (VDD/VDDo/(1 + a \times \Delta T).$$

Die zweite Stromkomponente ik2 wird mittels einer dritten Stromquelle q3 gebildet, die zur Stromeinstellung einen vierten Widerstand r4 enthält, dessen Halbleiterzone technologisch äquivalent zur Halbleiterzone des Hallelements h ist. Über diesem Widerstand r4 soll möglichst die Versorgungsspannung VDD oder ein zu ihr proportionaler Teil abfallen, so daß die gewünschte Abhängigkeit gewährleistet ist. Die in Fig. 2 dargestellte dritte Stromquelle q3 erfüllt diese Bedingung wegen der Serienschaltung des Widerstandes r4 mit der Basis-Emitter-Strecke des pnp-Stromspiegels nur näherungsweise. Exaktere Schaltungen, die jedoch aufwendiger sind, sind dem Fachmann für jede Technologie geläufig. Sie sind meist als Regelstufen ausgeführt.

Der Ausgang der Multipliziereinrichtung m liefert den Offsetstrom j mit der gewünschten Temperaturabhängigkeit nach Gleichung (9).

Bei der Realisierung der Multipliziereinrichtung m muß unterschieden werden, ob sie in Bipolar- oder in Feldeffekt-, insbesondere in CMOS-Technik, hergestellt werden soll. In der Bipolartechnik wird meist der exponentielle Kennlinienverlauf zwischen der Basis-Emitterspannung und dem Emitter- bzw. Kollektorstrom verwendet, während in der Feldeffekttransistortechnik der quadratische Zusammenhang zwischen der Gate-Source-Spannung und dem Drain-Strom verwendet wird. In beiden Fällen muß der Multipliziereinrichtung m an einem Bezugsstromeingang br eine dritte Stromkomponente ik3 zugeführt werden, die keine Temperaturabhängigkeit aufweisen darf. Die Erzeugung dieser dritten Stromkomponente ik3 durch eine gewichtete Addition/Subtraktion zweier Teilströme ist in Fig. 2 durch den fünften Schaltungsknoten k5 schematisch dargestellt. Ein derartiger temperaturunabhängiger Strom ist beispielsweise auch der temperaturunabhängige Strom ir1 im Ausführungsbeispiel nach Fig. 1. Eine ausführliche Erläuterung erübrigt sich somit.

Eine Multipliziereinrichtung m in CMOS-Technik ist beispielsweise ausführlich in "IEEE Journal of Solid-State-Circuits", Bd. SC-22, Nr. 3, Juni 1987, Seiten 357 bis 365 unter dem Titel: "A Class of Analog CMOS Circuits Based on the Square-Law Characteristic of an MOS Transistor in Saturation" beschrieben. Eine Multipliziereinrichtung in Bipolar-Technik ist beispielsweise in U. Tietze und Ch. Schenk, "Advanced Electronic Circuits", Springer-Verlag, 1978, Seiten 36 und 37 in Kapitel 1.8.2, "Multipliers with logarithmic function networks", beschrieben. Im dortigen Ausführungsbeispiel nach Fig. 1.39 ist die Multiplikation von zwei analogen Spannungswerten Ux und Uy unter Mitwirkung einer Bezugsspannung Uz dargestellt. Durch Weglassung der Eingangswiderstände R1, R2, R2' wird die Schaltung jedoch einfach für Eingangsströme umgerüstet. Ferner muß aus dem Spannungsausgang Uo mittels eines Spannungs-Stromumwandlers ein Stromausgang gebildet werden.

Das Ausführungsbeispiel nach Fig. 3 unterscheidet sich von dem Ausführungsbeispiel nach Fig. 2 lediglich dadurch, daß der Versorgungsanschluß 1 des Hallelements h nicht an der ungeregelten Versorgungsspannung VDD sondern an einer temperaturstabilisierten Hallelement-Versorgungsspannung V liegt. Die Hallelement-Versorgungsspannung V wird mittels einer geregelten Spannungsquelle vg erzeugt, die beispielsweise Teil der vorbeschriebenen Stromversorgungseinrichtungen gemäß Fig. 2 oder Fig. 3 sein kann. Am ehesten bietet sich hierzu eine Bandgap-Schaltung bg an, die bereits eine temperaturstabilisierte Ausgangsspannung vr erzeugt. Diese Spannung muß lediglich mittels bekannter Schaltungsmittel auf den Wert der Hallelement-Versorgungsspannung V hochtransformiert werden, wozu wieder entsprechende Regelschaltungen dienen.

Im Ausführungsbeispiel nach Fig. 1 ist die erste und zweite Stromquelle q1, q2 so miteinander verkoppelt, daß der zweite Hilfsstrom i2 am zweiten Widerstand r2 einen temperaturunabhängigen Spannungsabfall erzeugt. Da der Schichtwiderstand des Hallelements und des zweiten Widerstandes r2 technologisch zueinander äquivalent sind, erzeugt ein hochtransformierter Strom der zweiten Strombank b2 am ohmschen Widerstand R des Hallelements h einen Spannungsabfall, der ebenfalls temperaturunabhängig ist. Diese Realisierung ist in dem Ausführungsbeispiel nach Fig. 3 schematisch dargestellt, indem nämlich der Hallelement-Versorgungsanschluß 1 aus dem zweiten Stromumsetzer b2 gespeist wird.

Durch die temperaturstabilisierte Hallelement-Versorgungsspannung V vereinfacht sich die Schaltung im Bereich des Multiplizierers m, weil die zweite Stromkomponente ik2 nicht mehr erforderlich ist und nur noch die erste Stromkomponente ik1 gebildet werden muß, die dann aber quadriert wird. Die dem Bezugsstromeingang br zugeführte dritte Stromkomponente ik3 bleibt unverändert. Die Quadrierung der ersten Stromkomponente ik1 erfolgt mittels eines Quadrierers mq, der beispielsweise durch die vorbeschriebene Multipliziereinrichtung m gebildet wird, nur daß den beiden Multipliziereingängen jeweils die erste Stromkomponente ik1 zugeführt wird.

Die Quadrierung oder die Multiplikation der Stromkomponenten ik1, ik2 führt im resultierenden Strom j zu dem quadratischen Faktor $1/(1 + a \times \Delta T)^2$. Wenn $a \times \Delta T$ klein gegenüber 1 ist, dann kann der quadratische Ausdruck näherungsweise durch den Faktor $1/(1 + 2 \times a \times \Delta T)$ ersetzt werden. Ein Strom mit dieser Temperaturabhängigkeit kann aber durch die gewichtete Addition/Subtraktion zweier Teilströme gemäß dem Ausführungsbeispiel nach Fig. 1 erzeugt werden, wodurch das relativ aufwendige Multiplizieren oder Quadrieren von Strömen entfallen kann. In Fig. 3 ist diese Alternative durch den sechsten Schaltungsknoten k6 und die gestrichelt dargestellten Stromverbindungen zum ersten und zweiten Stromumsetzer b1, b2 angedeutet. Der Ausgang des sechsten Schaltungsknotens k6 liefert dann den gewünschten Offsetstrom j.

**Patentansprüche**

1. Kompensierter Hallsensor in monolithisch integrierter Schaltungstechnik mit einer mitintegrierten Stromversorgungseinrichtung für Betriebsströme,
gekennzeichnet durch folgende Merkmale:

   - die Stromversorgungseinrichtung enthält eine erste und eine zweite Stromquelle (ql, q2) für einen ersten bzw. einen zweiten Hilfsstrom i1, i2 mit einer ersten bzw. einer zweiten, von der ersten abweichenden Temperaturabhängigkeit,

   - die erste und die zweite Stromquelle (q1, q2) enthalten jeweils mindestens einen ersten bzw. einen zweiten Widerstand (r1, r2), deren Halbleiterzonen auf im wesentlichen gleiche Weise wie die Halbleiterzone des Hallelementes (h) hergestellt sind, wobei der Schichtwiderstand r' der Hallelement-Halbleiterzone als gemeinsamer temperatur- und technologieabhängiger Faktor
   $r' \times (1 + a \times \Delta T)$ die Größe und die Temperaturabhängigkeit des ersten und zweiten Hilfsstromes i1, i2 bestimmt, dabei ist:

      a = Temperaturkoeffizient des Schichtwiderstandes r' der Hallelement-Halbleiterzone, der auch als erster Koeffizient bezeichnet wird,
      T = absolute Temperatur, $T_o$ = Bezugstemperatur,
      $\Delta T = T - To$ = Bezugstemperaturdifferenz,

   - ein erster und ein zweiter Stromumsetzer (b1, b2) liefern erste bzw. zweite Teilströme (i11, i12, ..; i21, i22, ...), die fest vorgegebene Übersetzungsverhältnisse (c11, c12, ...; c21, c22...) gegenüber dem ersten bzw. zweiten Hilfsstrom i1, i2 aufweisen, und

   - Addier/Subtrahiereinrichtungen erzeugen durch Summen/Differenzbildung der ersten und zweiten Teilströme die Betriebsströme (iv, j) mit den gewünschten Temperaturabhängigkeiten.

2. Hallsensor nach Anspruch 1, dadurch gekennzeichnet, daß auf der Halbleiteroberfläche (ob) eine Fühlereinrichtung (k) für die Hallspannung (uh) mitintegriert ist.

3. Hallsensor nach Anspruch 2, gekennzeichnet durch folgende Merkmale:

   - die Betriebsströme enthalten einen Versorgungsstrom iv und einen Offsetstrom j,

   - eine Überlagerungseinrichtung (hs) überlagert der Hallspannung (uh) mittels des Offsetstromes j eine Offsetspannung (uj),

   - die Überlagerung erfolgt entweder unmittelbar am Hallelement (h) oder vom Hallelement dadurch entkoppelt, daß der Offsetstrom j in mindestens einen Hilfswiderstand (ra, ra') eingespeist ist, der auf im wesentlichen gleiche Weise wie die Halbleiterzone des Hallelementes (h) hergestellt ist, und

   - die Temperaturabhängigkeit des Offsetstromes j, die über das Teilstromverhältnis eingestellt ist, weist gegenüber der Temperaturabhängigkeit des Versorgungsstromes iv folgende Beziehung auf:

$$\Delta iv(T)/\Delta j(T) = 1 + a \times \Delta T,$$

   wobei folgende Definitionen gelten:

      a = Temperaturkoeffizient des Schichtwiderstandes der Hallelement-Halbleiterzone = erster Koeffizient,
      T = absolute Temperatur, To = Bezugstemperatur,
      $\Delta T = T - To$ = Bezugstemperaturdifferenz.

4. Hallsensor nach Anspruch 3, gekennzeichnet durch folgende Merkmale:

   - die Fühlereinrichtung ist ein Komparator (k) mit zwei Schaltzuständen,

EP 0 525 235 B1

- die Überlagerungseinrichtung enthält eine Hysterese-Schalteinrichtung (hs), die über die jeweilige Schaltstellung die Richtung der Hysteresespannung (uj) einstellt, und

- der Steuereingang der Hysterese-Schalteinrichtung (hs) ist mit dem Ausgang des Komparators (k) gekoppelt.

5. Hallsensor nach Anspruch 4, gekennzeichnet durch folgende Merkmale:

- die erste Stromquelle (q1) enthält eine Bandgap-Schaltung (bg), die mittels eines Transistorpaares (t1, t2), das ein Emitter-Flächenverhältnis A aufweist, und mittels des ersten Widerstandes (r1) den ersten Hilfsstrom i1 mit folgender Temperaturabhängigkeit erzeugt:

$$i1(T) = i1(To) \times (T/To)/(1 + a \times \Delta T)$$

- die zweite Stromquelle (q2) enthält den zweiten Widerstand (r2), an dem eine Spannung (vr) anliegt, die eine andere Temperaturabhängigkeit aufweist als die Spannung, die am ersten Widerstand (r1) liegt,

- die Temperaturabhängigkeit des zweiten Hilfsstromes i2 ist durch einen zweiten Koeffizient b und durch den ersten Koeffizient a wie folgt definiert:

$$i2(T) = i2(To) \times (1 + b \times \Delta T)/(1 + a \times \Delta T)$$

wobei
b = Temperaturkoeffizient der Spannung (vr) über dem zweiten Widerstand (r2) und

- als erster und zweiter Stromumsetzer dienen eine gesteuerte erste bzw. zweite Strombank (bl, b2), deren Ausgänge die als Gewichtungsfaktoren dienenden Teilströme (i11, i12, ...; i21, i22, ...) mit den vorgegebenen Übersetzungsverhältnissen (c11, c12, ..., c22, ...) liefern.

6. Hallsensor nach Anspruch 5, dadurch gekennzeichnet, daß die über dem zweiten Widerstand (r2) liegende Spannung (vr) eine temperaturstabilisierte Spannung aus einer Bandgap-Schaltung (bg) ist.

7. Verfahren zur Selbstkompensation eines Hallsensors bezüglich der herstellungsbedingten Empfindlichkeit und Temperaturabhängigkeit des Hallelements (h) durch folgende Verfahrensschritte:

- die für das Hallelement (h) erforderlichen Betriebsströme (iv, j) werden thermisch und technologisch fest mit dem Hallelement (h) gekoppelt, indem sie mittels einer Stromversorgungseinrichtung gebildet werden, die gemeinsam mit dem Hallelement (h) auf einer Halbleiteroberfläche (ob) monolithisch integriert wird,

- die Stromversorgungseinrichtung erzeugt einen ersten und einen zweiten Hilfsstrom i1, i2 mit einer ersten bzw. einer von der ersten abweichenden zweiten Temperaturabhängigkeit, wobei der Schichtwiderstand r' der Hallelement-Halbleiterzone als gemeinsamer temperatur- und technologieabhängiger Faktor r' $\times$ (1 + a $\times$ $\Delta T$) die Größe und Temperaturabhängigkeit des ersten und zweiten Hilfsstroms i1, i2 bestimmt, dabei ist:

a = Temperaturkoeffizient des Schichtwiderstandes r' der Hallelement-Halbleiterzone, der auch als erster Koeffizient bezeichnet wird,
T = absolute Temperatur, To = Bezugstemperatur,
$\Delta T = T - To = $ Bezugstemperaturdifferenz, und

- durch anteilige Addition oder Subtraktion des ersten und des zweiten Hilfsstroms i1, i2 mittels Addier/Subtrahiereinrichtungen (k1, k2, ...) werden die Betriebsströme (iv, j) für das Hallelement (h) gebildet, wobei durch die Größe der jeweiligen Hilfsstrom-Anteile die Temperaturabhängigkeiten der Betriebsströme vorgegeben werden.

8. Verfahren nach Anspruch 7, dadurch gekennzeichnet, daß in der Stromversorgungseinrichtung zur Stromeinstellung Widerstände (r1, r2) verwendet werden, die technologisch auf im wesentlichen gleiche Weise wie die Halbleiterzonen des Hallelementes (h) hergestellt sind.

**9.** Verfahren nach Anspruch 8, dadurch gekennzeichnet, daß die Betriebsströme für das Hallelement (h) durch einen Versorgungsstrom iv und einen Offsetstrom j gebildet werden, deren Temperaturabhängigkeiten wie folgt zusammenhängen:

$$\Delta iv(T)/\Delta j(T) = 1 + a \times \Delta T.$$

**10.** Verfahren nach Anspruch 8, gekennzeichnet durch folgende Merkmale:

- der erste Hilfsstrom il wird mittels einer Bandgap-Schaltung (bg) erzeugt, wobei die Größe des ersten Hilfsstroms i1 durch einen ersten Widerstand (r1), der technologisch auf im wesentlichen gleiche Weise wie die Halbleiterzone des Hallelementes (h) hergestellt ist, und ein Transistorpaar (t1, t2) mit einem Emitter-Flächenverhältnis A bestimmt wird,

- der zweite Hilfsstrom i2 wird mittels eines zweiten Widerstandes (r2) gebildet, der technologisch auf im wesentlichen gleiche Weise wie die Halbleiterzone des Hallelementes (h) hergestellt ist und über dem eine Spannung (vr) liegt, deren Temperaturabhängigkeit unterschiedlich zur Temperaturabhängigkeit der Spannung über dem ersten Widerstand (r1) ist.

**11.** Verfahren nach Anspruch 10, dadurch gekennzeichnet, daß die Spannung (vr) über dem zweiten Widerstand (r2) eine temperaturstabilisierte Spannung aus einer Bandgap-Schaltung (bg) ist.

**12.** Verfahren nach Anspruch 9, gekennzeichnet durch folgende Merkmale:

- der Versorgungsstrom iv wird so eingestellt, daß seine Temperaturabhängigkeit im Arbeitsbereich zu Null wird, und

- der Offsetstrom j wird so eingestellt, daß seine Temperaturabhängigkeit im Arbeitsbereich durch die Gleichung $j(T) = j(To) \times 1/(1 + a \times \Delta T)$ bestimmt wird.

**13.** Verfahren nach Anspruch 7, dadurch gekennzeichnet, daß mittels der Selbstkompensation auch die nichtlinearen Anteile der Temperaturabhängigkeiten verkleinert werden, indem bei der anteiligen Addition oder Subtraktion des ersten und zweiten Hilfsstroms i1, i2 außer den linearen Temperaturkoeffizienten mittels einer anteiligen zusätzlichen Addition oder Subtraktion des ersten und zweiten Hilfsstroms i1, i2 auch die nichtlinearen Temperaturkoeffizienten berücksichtigt werden, wobei die jeweiligen Anteile des ersten und zweiten Hilfsstromes i1, i2 durch weitere vorzugebende Übersetzungsverhältnisse (c13, ...) bestimmt werden.

**14.** Verfahren zur Selbstkompensation eines Hallsensors mit einer auf einer Halbleiteroberfläche (ob) mit dem Hallsensor mitintegrierten Fühlereinrichtung (k) für die Hallspannung (uh) und mit einer Hysterese-Schalteinrichtung (hs), dabei wird die Selbstkompensation des Hallelements (h) bezüglich der herstellungs- und temperaturbedingten Hysterese-Schaltempfindlichkeit durch folgende Verfahrensschritte bewirkt:

- ein für das Hallelement (h) erforderlicher Versorgungsstrom iv wird durch den Hallelement-Widerstand (R) und eine an ihm liegende, insbesondere ungeregelte, Versorgungsspannung VDD bestimmt,

- ein für die Hysterese-Schalteinrichtung (hs) in Verbindung mit dem Hallelement (h) erforderlicher Offsetstrom j wird thermisch und technologisch fest mit dem Hallelement (h) gekoppelt, indem er mittels einer Stromversorgungseinrichtung gebildet wird, die gemeinsam mit dem Hallelement (h) auf der Halbleiteroberfläche (ob) monolithisch integriert wird,

- der Offsetstrom j, der der Hysterese-Schalteinrichtung (hs) zugeführt ist, wird mittels einer Multipliziereinrichtung (m) aus einer ersten und einer zweiten Stromkomponente ikl, ik2 gebildet, wobei einem Bezugsstromeingang (br) der Multipliziereinrichtung (m) eine dritte Stromkomponente ik3 zugeführt ist, deren Temperaturabhängigkeit bei einer Bezugstemperatur To Null ist,

- die erste Stromkomponente ikl wird mittels einer ersten und einer zweiten Stromquelle (ql, q2) gebildet, die so ausgebildet sind und so zusammenwirken, daß die erste Stromkomponente ikl folgende Abhängigkeiten aufweist:

$$ik1(T) = ik1(To) \times 1/(1 + a \times \Delta T)$$

mit

a = Temperaturkoeffizient der Hallelement-Halbleiterzone, der auch als erster Koeffizient bezeichnet wird; T = absolute Temperatur; To = Bezugstemperatur und $\Delta T$ = T - To = Bezugstemperaturdifferenz,

- die zweite Stromkomponente ik2 wird mittels einer dritten Stromquelle (q3) gebildet, die so ausgebildet ist, daß die Versorgungsspannung VDD und ein Versorgungsspannungs-Bezugswert VDDo mit ihrer absoluten Größe und mit ihrer Temperaturabhängigkeit in die zweite Stromkomponente ik2 auf folgende Weise mit eingehen:

$$ik2(T,VDD) = ik2(To) \times (VDD/VDDo)/(1 + a \times \Delta T),$$

und

- die dritte Stromkomponente ik3 wird mittels eines Schaltungsknotens (k5) durch anteilige Addition oder Subtraktion eines ersten Hilfsstromes il aus der ersten Stromquelle (q1) und eines zweiten Hilfsstromes i2 mit einer anderen Temperaturabhängigkeit aus der zweiten Stromquelle (q2) gebildet, wobei die als Gewichtungsfaktoren dienenden jeweiligen Stromanteile so festgelegt werden, daß der resultierende Strom, der die dritte Stromkomponente ik3 bildet, mindestens im Abgleichpunkt To keine Temperaturabhängigkeit aufweist.

15. Verfahren zur Selbstkompensation eines Hallsensors mit einer auf einer Halbleiteroberfläche (ob) mit dem Hallsensor mitintegrierten Fühlereinrichtung (k) für die Hallspannung (uh) und mit einer Hysterese-Schalteinrichtung (hs), dabei wird die Selbstkompensation der Hallelements (h) bezüglich der herstellungs- und temperaturbedingten Hysterese-Schaltfindlichkeit durch folgende Verfahrensschritte bewirkt:

- ein für das Hallelement (h) erforderlicher Versorgungsstrom iv wird durch den Hallelement-Widerstand (R) und eine an ihm liegende spannungs- und temperaturstabilisierte Hallelement-Versorgungsspannung (V) aus einer geregelten Spannungsquelle (vg) bestimmt,

- ein für die Hysterese-Schalteinrichtung (hs) in Verbindung mit dem Hallelement (h) erforderlicher Offsetstrom j wird thermisch und technologisch fest mit dem Hallelement (h) gekoppelt, indem er mittels einer Stromversorgungseinrichtung gebildet wird, die gemeinsam mit dem Hallelement (h) auf der Halbleiteroberfläche (ob) monolithisch integriert wird,

- der Offsetstrom j, der der Hysterese-Schalteinrichtung (hs) zugeführt ist, wird mittels einer Quadriereinrichtung (mq) aus einer ersten und einer dritten Stromkomponente ik1, ik3 gebildet, wobei die erste Stromkomponente ik1 quadriert und die dritte Stromkomponente ik3 dem Bezugstromeingang (br) der Quadriereinrichtung (mq) zugeführt wird,

- die erste Stromkomponente ik1 wird mittels einer ersten und einer zweiten Stromquelle (q1, q2) gebildet, die so ausgebildet sind und so zusammenwirken, daß die erste Stromkomponente ik1 folgende Abhängigkeiten aufweist:

$$ik1(T) = ik1(To) \times 1/(1 + a \times \Delta T)$$

mit

a = Temperaturkoeffizient der Hallelement-Halbleiterzone, der auch als erster Koeffizient bezeichnet wird; T = absolute Temperatur; To = Bezugstemperatur und $\Delta T$ = T - To = Bezugstemperaturdifferenz,

- die dritte Stromkomponente ik3 wird mittels eines Schaltungsknotens (k5) durch anteilige Addition oder Subtraktion eines ersten Hilfsstromes il aus der ersten Stromquelle (q1) und eines zweiten Hilfsstromes i2 mit einer anderen Temperaturabhängigkeit aus der zweiten Stromquelle (q2) gebildet, wobei die als Gewichtungsfaktoren dienenden jeweiligen Stromanteile so festgelegt werden, daß der resultierende Strom ik3, der als dritte Stromkomponente dient, mindestens im Abgleichpunkt To keine Temperaturabhängigkeit aufweist.

**16.** Verfahren zur Selbstkompensation eines Hallsensors mit einer auf einer Halbleiteroberfläche (ob) mit dem Hallsensor mitintegrierten Fühlereinrichtung (k) für die Hallspannung (uh) und mit einer Hysterese-Schalteinrichtung (hs), dabei wird die Selbstkompenstion des Hallelements (h) bezüglich der herstellungs- und temperaturbedingten Hysterese-Schaltempfindlichkeit durch folgende Verfahrensschritte bewirkt:

- ein für das Hallelement (h) erforderlicher Versorgungsstrom iv wird durch den Hallelement-Widerstand (R) und eine an ihm liegende geregelte (V) oder ungeregelte Versorgungsspannung VDD bestimmt,

- ein für die Hysterese-Schalteinrichtung (hs) in Verbindung mit dem Hallelement (h) erforderlicher Offsetstrom j wird thermisch und technologisch fest mit dem Hallelement (h) gekoppelt, indem er mittels einer Stromversorgungseinrichtung gebildet wird, die gemeinsam mit dem Hallelement (h) auf der Halbleiteroberfläche (ob) monolithisch integriert wird,

- der Offsetstrom j, der der Hysterese-Schalteinrichtung (hs) zugeführt ist und dessen Temperaturabhängigkeit einen quadratischen temperaturabhängigen Faktor $1/(1 + a \times \Delta T)^2$ aufweisen soll, wird durch eine anteilige Addition oder Subtraktion eines ersten Hilfsstromes i1, mit einer ersten Temperaturabhängigkeit, aus einer ersten Stromquelle (q1) und eines zweiten Hilfsstromes i2 mit einer zweiten, anderen Temperaturabhängigkeit aus einer zweiten Stromquelle (q2) gebildet, wobei die Addition/Subtraktion mittels eines Schaltungsknotens (k6) erfolgt, an dem ein resultierender Strom j als Offsetstrom abgreifbar ist, dessen Temperaturabhängigkeit bei der Bezugstemperatur To näherungsweise durch den Faktor $1/(1 + 2a \times \Delta T)$ bestimmt wird, mit

  a = Temperaturkoeffizient der Hallelement-Halbleiterzone, der auch als erster Koeffizient bezeichnet wird;

  T = absolute Temperatur; To = Bezugstemperatur

  $\Delta T = T - To$ = Bezugstemperaturdifferenz.

## Claims

**1.** A compensated Hall sensor implemented in monolithic integrated circuit technology and comprising an integrated power supply device for operating currents,
<u>characterized by the following features:</u>

- The power supply device includes a first current source (q1) for a first auxiliary current i1 with a first temperature dependence and a second current source (q2) for a second auxiliary current i2 with a second temperature dependence different from the first;

- the first and second current sources (q1, q2) include a first resistor (r1) and a second resistor (r2), respectively, whose semiconductor regions are formed in essentially the same manner as the semiconductor region of the Hall element (h), with the sheet resistivity r' of the Hall element semiconductor region determining, as a common temperature- and technology-dependent factor $r' \times (1 + a \times \Delta T)$, the magnitudes and the temperature dependences of the first and second auxiliary currents i1, i2, where

  a = temperature coefficient of the sheet resistivity r' of the Hall element semiconductor region, also called the first coefficient

  T = absolute temperature

  $T_o$ = reference temperature

  $\Delta T = T - To$ = reference-temperature difference;

- a first current converter (b1) and a second current converter (b2) deliver first component currents (i11, i12, ...) and second component currents (i21, i22, ...), respectively, which have predetermined transformation ratios (c11, c12, ...; c21, c22, ) with respect to the first and second auxiliary currents i1, i2, respectively; and

- adding/subtracting devices generate the operating currents (iv, j) with the desired temperature dependences by summation/subtraction of the first and second component currents.

**2.** A Hall sensor as claimed in claim 1, characterized in that a sensing device (k) for sensing the Hall voltage (uh) is integrated on the chip surface (ob).

3. A Hall sensor as claimed in claim 2, characterized by the following features:

- The operating currents contain a supply current iv and an offset current j;

- a superposing device (hs) superposes an offset voltage (uj) on the Hall voltage (uh) by means of the offset current j;

- the superposition either takes place directly at the Hall element (h) or is decoupled from the Hall element as the offset current j is fed into at least one auxiliary resistor (ra, ra') which is formed in essentially the same manner as the semiconductor region of the Hall element (h); and

- the temperature dependence of the offset current j, which temperature dependence is set via the component-current ratio, is related to the temperature dependence of the supply current iv as follows:

$$\Delta iv(T)/\Delta j(T)=1+a\times\Delta T,$$

where

a = temperature coefficient of the sheet resistivity of the Hall element semiconductor region = first coefficient

T = absolute temperature

To = reference temperature

$\Delta T = T - To$ = reference-temperature difference

4. A Hall sensor as claimed in claim 3, characterized by the following features:

- The sensing device is a comparator (k) having two states;

- the superposing device includes a hysteresis switching device (hs) which determines the direction of the hysteresis voltage (uj) via the respective switch position; and

- the control input of the hysteresis switching device (hs) is connected to the output of the comparator (k).

5. A Hall sensor as claimed in claim 4, characterized by the following features:

- The first current source (q1) includes a band-gap circuit (bg) which, by means of a transistor pair (t1, t2) having an emitter-area ratio A and by means of the first resistor (r1), generates the first auxiliary current i1 with the following temperature dependence:

$$i1(T) = i1(To) \times (T/To)/(1 + a \times \Delta T);$$

- the second current source (q2) includes the second resistor (r2), across which appears a voltage (vr) having a temperature dependence different from that of the voltage across the first resistor (r1);

- the temperature dependence of the second auxiliary current i2 is defined by a second coefficient b and the first coefficient a as follows:

$$i2(T) = i2(To) \times (1 + b \times \Delta T)/(1 + a \times \Delta T),$$

where b = temperature coefficient of the voltage (vr) across the second resistor (r2); and

- the first and second current converters are a first controlled current bank (b1) and a second controlled current bank (b2) whose outputs deliver the component currents (i11, i12, ...; i21, i22, ...) with the predetermined transformation ratios (c11, c12, ...; c22, ...), said component currents serving as weighting factors.

6. A Hall sensor as claimed in claim 5, characterized in that the voltage (vr) across the second resistor (r2) is a temperature-stabilized voltage from the band-gap circuit (bg).

7. A method of automatically compensating a Hall sensor for the process-induced sensitivity and temperature dependence of the Hall element (h) by the following steps:

- The operating currents (iv, j) required for the Hall element (h) are thermally and technologically tightly coupled with the Hall element (h) by being formed by means of a power supply device which is integrated on the same chip surface (ob) as the Hall element (h);

- the power supply device generates a first auxiliary current i1 with a first temperature dependence and a second auxiliary current i2 with a second temperature dependence different from the first, with the sheet resistivity r' of the Hall element semiconductor region, as a common temperature- and technology-dependent factor $r' \times (1 + a \times \Delta T)$, determining the magnitudes and temperature dependences of the first and second auxiliary currents i1, i2, where

    a = temperature coefficient of the sheet resistivity r' of the Hall element semiconductor region, also called the first coefficient
    T = absolute temperature
    $T_o$ = reference temperature
    $\Delta T = T - To$ = reference-temperature difference;

- by proportionate addition or subtraction of the first and second auxiliary currents i1, i2 by means of adding/subtracting devices (k1, k2, ...), the operating currents (iv, j) for the Hall element (h) are formed, with the temperature dependences of the operating currents being determined by the magnitudes of the respective auxiliary-current portions.

8. A method as claimed in claim 7, characterized in that the power supply device includes current-setting resistors (r1, r2) which are formed in essentially the same manner as the semiconductor regions of the Hall element (h).

9. A method as claimed in claim 8, characterized in that the operating currents for the Hall element (h) are formed by a supply current iv and an offset current j whose temperature dependences are related as follows:

$$\Delta iv(T)/\Delta j(T) = 1 + a \times \Delta T.$$

10. A method as claimed in claim 8, characterized by the following features:

- The first auxiliary current il is generated by means of a band-gap circuit (bg), with the magnitude of the first auxiliary current i1 being determined by a first resistor (r1), which is formed in essentially the same manner as the semiconductor region of the Hall element (h), and a transistor pair (t1, t2) with an emitter-area retio A; and

- the second auxiliary current i2 is formed by means of a second resistor (r2), which is formed in essentially the same manner as the semiconductor region of the Hall element (h) and across which a voltage (vr) is developed whose temperature dependence is different from the temperature dependence of the voltage across the first resistor (r1).

11. A method as claimed in claim 10, characterized in that the voltage (vr) across the second resistor (r2) is a temperature-stabilized voltage from the band-gap circuit (bg).

12. A method as claimed in claim 9, characterized by the following features:

- The supply current iv is set so that its temperature dependence in the operating range becomes zero; and

- the offset current j is set so that its temperature dependence in the operating range is determined by the equation $j(T) = j(To) \times 1/(1 + a \times \Delta T)$.

13. A method as claimed in claim 7, characterized in that by means of the automatic compensation, the nonlinear portions of the temperature dependences are also reduced, namely by taking into account the nonlinear temperature coefficients in addition to the linear ones in the proportionate addition or subtraction of the first and second auxiliary currents i1, i2 by an additional proportionate addition or subtraction of the first and second auxiliary currents i1, i2, with the respective portions of the first and second auxiliary currents il, i2 being determined by further transformation ratios (c13, ...), which must be preset.

14. A method of automatically compensating a Hall sensor comprising a sensing device (k) for the Hall voltage (uh), which is integrated on the same semiconductor surface (ob) as the Hall sensor, and a hysteresis switching device (hs), the automatic compensation of the Hall element (h) with respect to the process- and temperature-induced hysteresis switching sensitivity being accomplished by the following steps:

- A supply current iv required for the Hall element (h) is determined by the Hall-element resistance (R) and a supply voltage VDD applied thereto, particularly an unregulated supply voltage;

- an offset current j required for the hysteresis switching device (hs) in conjunction with the Hall element (h) is thermally and technologically tightly coupled with the Hall element (h) by being formed by means of a power supply device which is integrated on the same chip surface (ob) as the Hall element (h);

- the offset current j, which is fed into the hysteresis switching device (hs), is formed from a first current component ikl and a second current component ik2 by means of a multiplier (m), with a reference current input (br) of the multiplier (m) receiving a third current component ik3 whose temperature dependence at a reference temperature To is zero;

- the first current component ik1 is formed by means of a first current source (q1) and a second current source (q2) which are designed and interact in such a way that the first current component ik1 has the following dependences:

$$ik1(T) = ik1(To) \times 1/(1 + a \times \Delta T),$$

where

    a = temperature coefficient of the Hall element semiconductor region, also called the first coefficient
    T = absolute temperature
    $T_o$ = reference temperature
    $\Delta T = T - To$ = reference-temperature difference;

- the second current component ik2 is formed by means of a third current source (q3) which is so designed that the supply voltage VDD and a supply voltage reference value VDDo enter with their absolute values and their temperature dependences into the second current component ik2 as follows:

$$ik2(T, VDD) = ik2(To) \times (VDD/VDDo)/(1 + a \times \Delta T);$$

and

- the third current component ik3 is formed by means of a node (k5) by proportionate addition or subtraction of a first auxiliary current il from the first current source (q1) and a second auxiliary current i2 with another temperature dependence from the second current source (q2), with the respective current portions, which serve as weighting factors, being fixed so that the resultant current, which forms the third current component ik3, exhibits no temperature dependence at least at the balance point To.

15. A method of automatically compensating a Hall sensor comprising a sensing device (k) for the Hall voltage (uh), which is integrated on the same semiconductor surface (ob) as the Hall sensor, and a hysteresis switching device (hs), the automatic compensation of the Hall element (h) with respect to the process- and temperature-induced hysteresis switching sensitivity being accomplished by the following steps:

- A supply current iv required for the Hall element (h) is determined by the Hall-element resistance (R) and a voltage- and temperature-stabilized Hall element supply voltage (V) applied thereto from a regulated voltage source (vg);

- an offset current j required for the hysteresis switching device (hs) in conjunction with the Hall element (h) is thermally and technologically tightly coupled with the Hall element (h) by being formed by means of a power supply device which is integrated on the same chip surface (ob) as the Hall element (h);

the offset current j, which is fed into the hysteresis switching device (hs), is formed from a first current component ikl and a third current component ik3 by means of a squarer (mq), with the first current component ikl being squared and the third current component ik3 being applied to the reference current input (br) of the squarer (mq);

- the first current component ikl is formed by means of a first current source (q1) and a second current source (q2) which are designed and interact in such a way that the first current component ik1 has the following dependences:

$$ik1(T) = ik1(To) \times 1/(1 + a \times \Delta T)$$

where

a = temperature coefficient of the Hall element semiconductor region, also called the first coefficient
T = absolute temperature
$T_o$ = reference temperature
$\Delta T$ = T - To = reference-temperature difference;

- the first current component ik3 is formed by means of a node (k5) by proportionate addition or subtraction of a first auxiliary current i1 from the first current source (q1) and a second auxiliary current i2 with another temperature dependence from the second current source (q2), with the respective current portions, which serve as weighting factors, being fixed so that the resultant current ik3, which serves as the third current component, exhibits no temperature dependence at least at the balance point To.

16. A method of automatically compensating a Hall sensor comprising a sensing device (k) for the Hall voltage (uh), which is integrated on the same semiconductor surface (ob) as the Hall sensor, and a hysteresis switching device (hs), the automatic compensation of the Hall element (h) with respect to the process- and temperature-induced hysteresis switching sensitivity being accomplished by the following steps:

- A supply current iv required for the Hall element (h) is determined by the Hall-element resistance (R) and a regulated (V) or unregulated supply voltage VDD applied thereto;

- an offset current j required for the hysteresis switching device (hs) in conjunction with the Hall element (h) is thermally and technologically tightly coupled with the Hall element (h) by being formed by means of a power supply device which is integrated on the same chip surface (ob) as the Hall element (h); and

- the offset current j, which is fed into the hysteresis switching device (hs) and whose temperature dependence is to have a quadratic, temperature-dependent factor $1/(1 + a \times \Delta T)^2$, is formed by proportionate addition or subtraction of a first auxiliary current il with a first temperature dependence from a first current source (q1) and a second auxiliary current i2 with a second, other temperature dependence from a second current source (q2), the addition/subtraction being performed by means of a node (k6) from which a resultant current j is available as an offset current whose temperature dependence at the reference temperature To is determined approximately by the factor $1/(1 + 2a \times \Delta T)$, where

a = temperature coefficient of the Hall element semiconductor region, also called the first coefficient
T = absolute temperature
$T_o$ = reference temperature
$\Delta T$ = T - To = reference-temperature difference.

**Revendications**

1. Capteur à effet Hall compensé réalisé selon la technique des circuits intégrés monolithiques et comportant un dispositif d'alimentation en courant intégré pour des courants de service,

     <u>caractérisé par les particularités suivantes :</u>

   - le dispositif d'alimentation en courant comprend une première et une deuxième source de courant (q1, q2) pour un premier, respectivement deuxième, courant auxiliaire (il) et (i2) présentant une première, respectivement une deuxième, différente de la première, dépendance par rapport à la température,
   - les première et deuxième sources de courant (q1, q2) comprennent chacune au moins une première, respectivement une deuxième, résistance (r1, r2) dont les zones à semi-conducteur sont fabriquées d'une manière substantiellement semblable à la zone à semi-conducteur de l'élément à effet Hall, la résistance série (r') de la zone à semi-conducteur de l'élément à effet Hall déterminant en tant que facteur commun dépendant de la température et de la technologie r' * (1 + a * $\Delta T$), la grandeur et la dépendance par rapport à la température des premier et deuxième courants auxiliaires (il) et (i2), avec :

        a = le coefficient de température de la résistance série r' de la zone à semi-conducteur de l'élément à effet Hall, qui est aussi désigné par premier coefficient,
        T = la température absolue, To = la température de référence,
        $\Delta T$ = T - To = la différence de la température de référence,

   - un premier et respectivement un deuxième transformateur de courant (b1, b2) fournissent des premiers, respectivement des deuxièmes courants partiels (i11, i12, ..; i21, i22, ) qui présentent des rapports de transformation prédéterminés de manière fixe (c11, c12, ... ; c21, c22, ...) par rapport aux premier, respectivement deuxième, courant auxiliaires (il) et (i2) et
   - des dispositifs d'addition/soustraction produisent, par formation de sommes/différences des premiers et deuxièmes courants partiels, les courants de service (iv, j) avec les dépendances par rapport à la température désirées.

2. Capteur à effet Hall selon la revendication 1, caractérisé en ce qu'un dispositif capteur (k) pour la tension de Hall (uh) est intégré sur la surface du semi-conducteur (ob).

3. Capteur à effet Hall selon la revendication 2, caractérisé par les particularités suivantes :

   - les courants de service comprennent un courant d'alimentation iv et un courant de décalage (j),
   - un dispositif de superposition (hs) superpose une tension de décalage (uj) à la tension de Hall (uh), au moyen du courant de décalage (j),
   - la superposition est réalisée soit directement sur l'élément à effet Hall (h), soit par l'élément à effet Hall découplé par le fait que le courant de décalage (j) est envoyé dans au moins une résistance auxiliaire (ra, ra') qui est essentiellement fabriquée de la même manière que la zone à semi-conducteur de l'élément à effet Hall (h) et
   - la dépendance par rapport à la température du courant de décalage j, qui est réglée au moyen du rapport de courant partiel, présente, par rapport à la dépendance par rapport à la température du courant d'alimentation (iv), la relation suivante :

$$\Delta iv(T)/\Delta j(T) = 1 + a * \Delta T$$

     avec les définitions suivantes :

        a = le coefficient de température de la résistance série de la zone à semi-conducteur de l'élément à effet Hall = le premier coefficient,
        T = la température absolue, To = la température de référence,
        $\Delta T$ = T - To = la différence de la température de référence.

4. Capteur à effet Hall selon la revendication 3, caractérisé par les particularités suivantes :

   - le dispositif capteur est un comparateur présentant deux états de commutation,

- le dispositif de superposition comprend un dispositif de commutation à hystérésis (hs) qui règle, par la position de commutation respective, la direction de la tension de décalage (uj), et
- l'entrée de commande du dispositif de commutation à hystérésis (hs) est couplée avec la sortie du comparateur (k).

5. Capteur à effet Hall selon la revendication 4, caractérisé par les particularités suivantes :

- la première source de courant (q1) comprend un circuit à bande interdite (bg) qui, au moyen d'une paire de transistors (t1, t2) qui présente un rapport émetteur-surface A et au moyen de la première résistance (r1), produit le premier courant auxiliaire (i1) avec la dépendance par rapport à la température suivante :

$$i1(T) = i1(To) * (T/To)/(1 + a * \Delta T)$$

- la deuxième source de courant (q2) comprend la deuxième résistance (r2) aux bornes de laquelle existe une tension (vr) qui présente une dépendance par rapport à la température différente de celle de la tension qui existe aux bornes de la première résistance (r1),
- la dépendance par rapport à la température du deuxième courant auxiliaire i2 est définie par un deuxième coefficient b et par le premier coefficient a de la manière suivante :

$$i2(T) = i2(To) * (1 + b * \Delta T)/(1 + a * \Delta T)$$

où
b = le coefficient de température de la tension (vr) existant aux bornes de la deuxième résistance (r2)
et
- en tant que premier et deuxième transformateurs de courant, on utilise un premier, respectivement deuxième, banc de courant commandé (b1, b2) dont les sorties fournissent les courants partiels (i11, i12, ... ; i21, i22, ...) servant de facteurs de pondération avec les rapports de transformation prédéterminés (c11, c12, ... ; c21, c22, ...).

6. Capteur à effet Hall selon la revendication 5, caractérisé en ce que la tension (vr) existant aux bornes de la deuxième résistance (r2) est une tension stabilisée en température provenant d'un circuit à bande interdite (bg).

7. Procédé pour l'autocompensation d'un capteur à effet Hall en ce qui concerne la sensibilité conditionnée par la fabrication et la dépendance par rapport à la température de l'élément à effet Hall (h), comportant les étapes de procédé suivantes :

- les courants de service (iv, j) nécessaires pour l'élément à effet Hall (h) sont couplés de manière fixe du point de vue thermique et technologique avec l'élément à effet Hall (h) par le fait qu'ils sont formés au moyen d'un dispositif d'alimentation en courant qui est intégré de manière monolithique conjointement avec l'élément à effet Hall (h) sur une surface de semi-conducteur (ob),
- le dispositif d'alimentation en courant produit un premier et deuxième courant auxiliaire (il) et (i2) présentant une première, respectivement une deuxième, différente de la première, dépendance par rapport à la température, la résistance série (r') de la zone à semi-conducteur de l'élément à effet Hall déterminant en tant que facteur commun dépendant de la température et de la technologie r' * (1 + a * $\Delta T$), la grandeur et la dépendance par rapport à la température des premier et deuxième courants auxiliaires (i1) et (i2), avec :

a = le coefficient de température de la résistance série r' de la zone à semi-conducteur de l'élément à effet Hall, qui est aussi désigné par premier coefficient,
T = la température absolue, To = la température de référence,
$\Delta T = T - To$ = la différence de la température de référence et

- par addition ou soustraction proportionnelle des premier et deuxième courants auxiliaires (i1) et (i2) au moyen de dispositifs d'addition/soustraction (k1, k2, ...), on forme les courants de service (iv, j) pour l'élément à effet Hall (h), les dépendances par rapport à la température des courants de service étant prédéterminées par la grandeur des proportions respectives de courant auxiliaire.

**8.** Procédé selon la revendication 7, caractérisé en ce que, dans le dispositif d'alimentation en courant destiné au réglage du courant, on utilise des résistances (r1, r2) qui sont fabriquées, du point de vue technologique, essentiellement de la même manière que les zones à semi-conducteur de l'élément à effet Hall (h).

**9.** Procédé selon la revendication 8, caractérisé en ce que les courants de service sont constitués par un courant d'alimentation (iv) et un courant de décalage (j) dont les dépendances par rapport à la température sont reliées de la manière suivante :

$$\Delta iv(T)/\Delta j(T) = (1 + a * \Delta T).$$

**10.** Procédé selon la revendication 8, caractérisé par les particularités suivantes :

- le premier courant auxiliaire (il) est produit par un circuit à bande interdite (bg), la grandeur du premier courant auxiliaire (il) étant déterminée par une première résistance (rl), qui est fabriquée, du point de vue technologique, essentiellement de la même manière que la zone à semi-conducteur de l'élément à effet Hall (h), et par une paire de transistors (t1, t2) qui présente un rapport émetteur-surface A,
- le deuxième courant auxiliaire (i2) est formé par une deuxième résistance (r2) qui, du point de vue technologique, est fabriquée essentiellement de la même manière que la zone à semi-conducteur de l'élément à effet Hall (h) et aux bornes de laquelle existe une tension (vr) dont la dépendance par rapport à la température diffère de la dépendance par rapport à la température de la tension existant aux bornes de la première résistance (r1).

**11.** Procédé selon la revendication 10, caractérisé en ce que la tension (vr) existant aux bornes de la deuxième résistance (r2) est une tension stabilisée en température provenant d'un circuit à bande interdite (bg).

**12.** Procédé selon la revendication 9, caractérisé par les particularités suivantes :

- le courant d'alimentation (iv) est réglé de telle manière que sa dépendance par rapport à la température est rendue égale à zéro dans la gamme de travail, et
- le courant de décalage (j) est réglé de telle manière que sa dépendance par rapport à la température dans la gamme de travail est déterminée par l'équation $j(T) = j(To) * 1/(1 + a * \Delta T)$.

**13.** Procédé selon la revendication 7, caractérisé en ce que, au moyen de l'autocompensation, on réduit aussi les parties non linéaires des dépendances par rapport à la température par le fait que, dans le cas de l'addition ou de la soustraction proportionnelle des premier et deuxième courants auxiliaires (il) et (i2), on prend en compte, en plus des coefficients de température linéaires, au moyen d'une addition ou d'une soustraction proportionnelle supplémentaire des premier et deuxième courants auxiliaires (il) et (i2), également les coefficients de température non linéaires, les proportions respectives des premier et deuxième courants auxiliaires (il) et (i2) étant déterminées par d'autres rapports de transformation devant être prédéterminés (c13, ...).

**14.** Procédé pour l'autocompensation d'un capteur à effet Hall comportant un dispositif capteur (k) pour la tension de Hall (uh), intégré avec le capteur à effet Hall sur la surface de semi-conducteur (ob), et un dispositif de commutation à hystérésis (hs), l'autocompensation de l'élément à effet Hall (h) en ce qui concerne la sensibilité de commutation à hystérésis conditionnée par la fabrication et la température étant causée par les étapes de procédé suivantes :

- un courant d'alimentation iv nécessaire pour l'élément à effet Hall (h) est déterminé par la résistance (R) de l'élément à effet Hall et par une tension d'alimentation VDD, en particulier non régulée, existant à ses bornes,
- un courant de décalage (j) nécessaire pour le dispositif de commutation à hystérésis (hs) en liaison avec l'élément à effet Hall (h) est couplé de manière fixe du point de vue thermique et technologique avec l'élément à effet Hall (h) par le fait qu'il est formé au moyen d'un dispositif d'alimentation en courant qui est intégré de manière monolithique conjointement avec l'élément à effet Hall (h) sur la surface de semi-conducteur (ob),
- le courant de décalage (j), qui est envoyé au dispositif de commutation à hystérésis (hs), est formé, au moyen d'un dispositif de multiplication (m), à partir d'une première et d'une deuxième composante de courant (ik1) et (ik2), une troisième composante de courant (ik3), dont la dépendance par rapport à la température est égale à zéro pour une température de référence To, étant envoyée sur une entrée de courant de référence (br) du dispositif de multiplication (m),
- la première composante de courant (ik1) est formée par une première et une deuxième source de courant (q1, q2) qui sont conformées et coopèrent de telle manière que la première composante de courant (ik1) présente les dépendances suivantes :

$$ik1(T) = ik1(To) * 1/(1 + a * \Delta T)$$

avec

  a = le coefficient de température de la zone à semi-conducteur de l'élément à effet Hall, qui est aussi désigné par premier coefficient ; T = la température absolue ; To = la température de référence; $\Delta T$ = T - To = la différence de la température de référence,

- la deuxième composante de courant (ik2) est formée au moyen d'une troisième source de tension (q3) qui est conformée de telle manière que la tension d'alimentation VDD et une valeur de référence VDDo de la tension d'alimentation interviennent par leur grandeur absolue et leur dépendance par rapport à la température dans la deuxième composante de courant (ik2) de la manière suivante :

$$ik2(T, VDD) = ik2(To) * (VDD/VDDo)/(1 + a * \Delta T)$$

et

- la troisième composante de courant (ik3) est formée au moyen d'un noeud de commutation (k5) par addition ou soustraction proportionnelle d'un premier courant auxiliaire (i1) provenant de la première source de courant (q1) et d'un deuxième courant auxiliaire (i2) présentant une autre dépendance par rapport à la température et provenant de la deuxième source de courant (q2), les proportions respectives de courant servant de facteurs de pondération étant fixées de telle manière que le courant résultant, qui forme la troisième composante de courant (ik3), ne présente pas de dépendance par rapport à la température au moins au point de réglage To.

15. Procédé pour l'autocompensation d'un capteur à effet Hall comportant un dispositif capteur (k) pour la tension de Hall (uh), intégré avec le capteur à effet Hall sur la surface de semi-conducteur (ob), et un dispositif de commutation à hystérésis (hs), l'autocompensation de l'élément à effet Hall (h) en ce qui concerne la sensibilité de commutation à hystérésis conditionnée par la fabrication et la température étant causée par les étapes de procédé suivantes :

- un courant d'alimentation (iv) nécessaire pour l'élément à effet Hall (h) est déterminé par la résistance (R) de l'élément à effet Hall et par une tension d'alimentation (V) de l'élément à effet Hall appliquée sur cette résistance, stabilisée en tension et en température et provenant d'une source de tension régulée (vg),
- un courant de décalage (j) nécessaire pour le dispositif de commutation à hystérésis (hs) en liaison avec l'élément à effet Hall (h) est couplé de manière fixe du point de vue thermique et technologique avec l'élément à effet Hall (h) par le fait qu'il est formé au moyen d'un dispositif d'alimentation en courant qui est intégré de manière monolithique conjointement avec l'élément à effet Hall (h) sur la surface de semi-conducteur (ob),
- le courant de décalage (j), qui est envoyé au dispositif de commutation à hystérésis (hs), est formé, au moyen d'un dispositif d'élévation au carré (mq), à partir d'une première et d'une troisième composante de courant (ik1) et (ik3), la première composante de courant (ik1) étant élevée au carré et la troisième composante de courant (ik3) étant envoyée à l'entrée de courant de référence (br) du dispositif d'élévation au carré (mq),
- la première composante de courant (ik1) est formée au moyen d'une première et d'une deuxième source de courant (q1, q2) qui sont conformés et coopèrent de telle manière que la première composante de courant (ik1) présente les dépendances suivantes :

$$ik1(T) = ik1(To) * 1/(1 + a * \Delta T)$$

avec

  a = le coefficient de température de la zone à semi-conducteur de l'élément à effet Hall, qui est aussi désigné par premier coefficient ; T = la température absolue ; To = la température de référence ; $\Delta T$ = T - To = la différence de la température de référence,

- la troisième composante de courant (ik3) est formée au moyen d'un noeud de commutation (k5) par addition ou soustraction proportionnelle d'un premier courant auxiliaire (i1) provenant de la première source de courant (q1) et d'un deuxième courant auxiliaire (i2) présentant une autre dépendance par rapport à la température et provenant de la deuxième source de courant (q2), les proportions respectives de courant servant de facteurs de pondération étant fixées de telle manière que le courant résultant (ik3), en tant que troisième composante

**EP 0 525 235 B1**

de courant, ne présente pas de dépendance par rapport à la température au moins au point de réglage To.

16. Procédé pour l'autocompensation d'un capteur à effet Hall comportant un dispositif capteur (k) pour la tension de Hall (uh), intégré avec le capteur à effet Hall sur la surface de semi-conducteur (ob), et un dispositif de commutation à hystérésis (hs), l'autocompensation de l'élément à effet Hall (h) en ce qui concerne la sensibilité de commutation à hystérésis conditionnée par la fabrication et la température étant causée par les étapes de procédé suivantes :

- un courant d'alimentation (iv) nécessaire pour l'élément à effet Hall (h) est déterminé par la résistance (R) de l'élément à effet Hall et par une tension d'alimentation (V) régulée qui lui est appliquée ou par une tension d'alimentation VDD non régulée qui lui est appliquée,
- un courant de décalage (j) nécessaire pour le dispositif de commutation à hystérésis (hs) en liaison avec l'élément à effet Hall (h) est couplé de manière fixe du point de vue thermique et technologique avec l'élément à effet Hall (h) par le fait qu'il est formé au moyen d'un dispositif d'alimentation en courant qui est intégré de manière monolithique conjointement avec l'élément à effet Hall (h) sur la surface de semi-conducteur (ob),
- le courant de décalage (j), qui est envoyé au dispositif de commutation à hystérésis (hs) et dont la dépendance par rapport à la température doit comporter un facteur quadratique dépendant de la température $1/(1 + a * \Delta T)^2$, est formé par une addition ou une soustraction proportionnelle d'un premier courant auxiliaire (i1présentant une première dépendance par rapport à la température et provenant d'une première source de courant (q1) et d'un deuxième courant auxiliaire (i2) présentant une deuxième dépendance différente par rapport à la température et provenant d'une deuxième source de courant (q2), l'addition/soustraction étant réalisée au moyen d'un noeud de commutation (k6) sur lequel on peut prélever un courant j en tant que courant de décalage dont la dépendance par rapport à la température est déterminée, à la température de référence To, de manière approximative par le facteur

$$1/(1 + 2 * a * \Delta T),$$

avec :
a = le coefficient de température de la zone à semi-conducteur de l'élément à effet Hall, qui est aussi désigné par premier coefficient ; T = la température absolue ; To = la température de référence ; $\Delta T = T - To$ = la différence de la température de référence.

Fig.1

Fig.2

EP 0 525 235 B1

Fig.3

EP 0 525 235 B1